Europäisches Patentamt

European Patent Office

Office européen des brevets

(11) Publication number: **0 151 309**
**B1**

(12) **EUROPEAN PATENT SPECIFICATION**

(45) Date of publication of patent specification: **23.05.90**

(51) Int. Cl.⁵: **H 01 L 29/80**, H 01 L 29/36

(21) Application number: **84116162.3**

(22) Date of filing: **21.12.84**

(54) **High Electron Mobility Field-Effect Transistor.**

(30) Priority: **28.12.83 JP 246273/83**

(43) Date of publication of application:
**14.08.85 Bulletin 85/33**

(45) Publication of the grant of the patent:
**23.05.90 Bulletin 90/21**

(84) Designated Contracting States:
**DE FR GB NL**

(56) References cited:
**EP-A-0 005 059**

**JAPANESE JOURNAL OF APPLIED PHYSICS,
vol. 20, no. 5, May 1981, pages L317-L319,
Tokyo, JP; T. MIMURA et al.: "Enhancement-
mode high electron mobility transistors for logic
applications"
EXTENDED ABSTRACTS OF THE JOURNAL OF
THE ELECTROCHEMICAL SOCIETY, vol. 80-2,
October 1980, pages 1186-1187, Abstract no.
476, Princeton, New Jersey, US; P.K. VASUDEV
et al.: "High resistivity GaAs and AlGaAs buffer
layers for MESFET and IC applications"**

(73) Proprietor: **HITACHI, LTD.**
**6, Kanda Surugadai 4-chome Chiyoda-ku
Tokyo (JP)**

(72) Inventor: **Shiraki, Yasuhiro**
**1-106, 3-26-1,Hirayama
Hino-shi Tokyo (JP)**
Inventor: **Katayama, Yoshifumi**
**1303-9, Shimotomi Tokorozawa-shi
Saitama-ken (JP)**
Inventor: **Murayama, Yoshimasa**
**4-2-1-320, Maehara-cho
Koganei-shi Tokyo (JP)**
Inventor: **Morioka, Makoto**
**2196-64, Hirai Hinodemachi
Nishitama-gun Tokyo (JP)**
Inventor: **Sawada, Yasushi**
**Hitachi-dai 2 kyoshin-ryo, 3-1,Higashi-koigakubo
Kokubunji-shi Tokyo (JP)**
Inventor: **Mishima, Tomoyoshi**
**1-12-10, Kamimuneoka, Shiki-shi
Saitama-ken (JP)**
Inventor: **Kuroda, Takao**
**Hitachi-dai 4 Kyoshin-ryo 4-14-6 Nishi-
koigakubo**

(56) References cited:

**APPLIED PHYSICS LETTERS, vol. 41, no. 6, September 1982, pages 563-565, American Institute of Physics, New York, US; W. KOPP et al.: "Use of a GaAs smoothing layer to improve the heterointerface of GaAs/AlxGa1-xAs field-effect transistors"**

**Kokubunji-shi Tokyo (JP)**
Inventor: **Maruyama, Eiichi**
**1572-3, Jousuihoncho**
**Kodaira-shi Tokyo (JP)**


(74) Representative: **Strehl, Schübel-Hopf, Groening**
**Maximilianstrasse 54 Postfach 22 14 55**
**D-8000 München 22 (DE)**

## Description

Background of the invention
Field of the invention
This invention relates to a semiconductor device using carriers derived from a semiconductor hetero-structure interface.

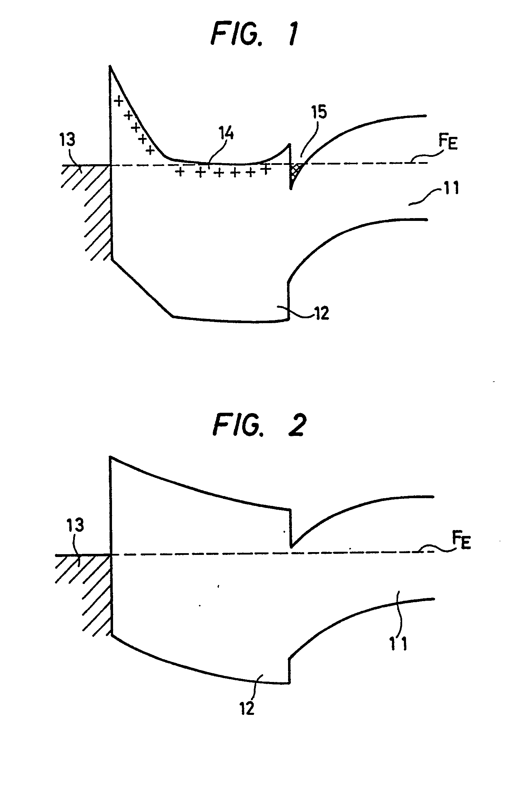

Description of the prior art
Gallium arsenide (GaAs), having a much higher mobility of electrons than silicon, is suitable for producing a fast device. However, production of a MOS (Metal-Oxide-Semiconductor) type of field effect transistor using GaAs, similar to that using silicon was impossible, because of the difficulty in the formation of a good insulator when using GaAs. Recently, it has been found that the employment of a hetero-structure of GaAs and aluminium gallium arsenide (AlGaAs) containing donor impurities can provide a field effect transistor owing to the generation of carriers at the interface. Fig. 1 shows the drawing of band structure of the above-mentioned transistor's working area wherein 13 is an electrode portion, 12 an AlGaAs layer containing an impurity, and 11 a GaAs layer containing substantially no impurity. Fe indicates the Fermi level. In Fig. 1, 15 indicates the carriers confined in the triangular potential well. Since the carriers 15 which are provided from the donor impurity (14) in AlGaAs (12) transit through GaAs containing no impurities, they are separately placed from the ionized donor impurity. As a result, the scattering of electrons due to the impurity potential can be greatly reduced and high mobility can be achieved. However, in transistors of such structure with high mobility electrons, the transconductance becomes small because the gate voltage is not effectively applied to the interface due to the larger addition of donor impurity. In order to avoid this effect, it is desirable to use AlGaAs containing no impurities as in the MOS structure. However, in the case of a Schottky type gate, there are gaps between the source and drain electrodes and the channel, which differs from the MOS structure. Accordingly, when no donor impurity is added, no carriers are induced in this gap portion, so that the channel and the source-drain electrodes cannot be connected to work as a transistor.

Japanese Journal of Applied Physics, Vol. 20, No. 5, May 1981, pp L 317—L 319, discloses a high electron mobility FET which comprises a hetero-junction formed by an undoped GaAs layer and a uniformly doped double layer consisting of a first $Al_{0.3}Ga_{0.7}As$-sublayer and a second $Al_xGa_{1-x}As$-sublayer, the Al-content in the seond sublayer declining to zero for lattice-matching with an additional doped GaAs surface layer.

It is to be noted that the above examples are given in Japanese Journal of Applied Physics Vol. 19, No. 5, May, 1980, pp L225—L227 and Microwaves, October, 1980, p. 20.

There has been proposed a field effect transistor characterized by introducing donor impurities into the gate electrode-side semiconductor having the wide forbidden band in the gap area between the channel and the source-drain electrodes, such as AlGaAs in the above-mentioned example, and by introducing no impurity in the channel portion directly under the gate electrode. Fig. 2 shows the band diagram in the working area of the above-mentioned field effect transistor, wherein 13 is an electrode portion, 12 an AlGaAs layer, 11 a GaAs layer and $F_E$ the Fermi level, similar to Fig. 1. Such structure has the following characteristic features:

(1) Mobility increases because there are no impurities in AlGaAs near the channel which act as scattering centers.

(2) Transconductance can be increased by effectively applying a gate voltage to the channel portion because the AlGaAs layer can have the same effect as the insulating layer in the MOS structure.

(3) The channel portion and the source-drain electrodes can be connected to work as a transistor by introducing donor impurities in the gap area between the channel and electrodes.

However, in the case of the above-mentioned transistor, the source-drain electrodes are generally formed by ion implantation. In this case, when the composition ratio of Al in AlGaAs is at least 0.25, the activation efficiency of the introduced impurities is not high, so that the resistance in the electrode portions becomes higher, to exert a harmful influence on speeding up the movement of electrons.

Summary of the invention
This invention as defined in the claims relates to an improvement of the latter semiconductor device described above. Namely, this invention is directed to an improvement of a semiconductor device comprising a hetero-junction of first and second semiconductor layers containing substantially no impurity and by using a potential well formed on the interface as a carrier-transmitting area.

This invention can effectively lower the resistance value of the semiconductor area to constitute means of transmitting and receiving carriers to bring about the fast response of the semiconductor device.

The fundamental idea of this invention is shown as follows.

The semiconductor area constituting the means of transmitting and receiving carriers at both end portions of the channel usually consists of the first and the second semi-conductor layers which form the hetero-junction to constitute the carrier-transmitting area. Either one of the first and the second semiconductor layers consists of a semiconductive material having the wide forbidden band, which operates as the so-called barrier layer. In this invention, at least one semiconductor layer having a good activation efficiency of impurity is inserted into another surface side opposite to the surface constituting the channel of said barrier layer before the introduction of impurity so that these semiconductor layers produce the hetero-junction structure. Usually the more narrow forbidden band of the semiconductor layer shows the higher activation efficiency of impurity. The first impurity area consists of the source-drain areas including the resulting laminated layer area. This first impurity area is usually formed by a method of implanting ions. The implantation energy and dose are determined so that the impurity concentration is a volume concentration in the range from $5 \times 10^{17}$ to $5 \times 10^{19} cm^{-3}$.

Moreover, the source and drain electrodes are usually formed in the first impurity area by alloying. It is a matter of course that these electrodes can be a non-alloy type of electrodes by using an epitaxial layer containing a highly-concentrated impurity without employing the alloying method. In this case, the impurity concentration is approximately $5 \times 10^{18} cm^{-3}$.

In said insular first impurity area, the presence of the semiconductor layer having a high activation efficiency of impurity brings about the connection to the channel, generates carriers suitable for the hetero-junction area extending into the first impurity area, and substantially lowers the resistance value of the impurity area. Accordingly, the connection to the source and drain electrodes becomes quite good.

Further, the semiconductor layer area existing between the means of transmitting and receiving carriers has an area containing only $10^{16} cm^{-3}$ or less of impurity without impairing the advantages of the claimed semiconductor device of this invention.

As to said semiconductor layer having a high activation efficiency of an impurity, there may be used plural layers thereof. Or these layers may be comprised of the wider forbidden band layer and the more narrow forbidden band layer laminated one after the other, a so-called multiquantum well. In this case, the thickness of the layer may be in a range from 1 to 10 nm, and that of the whole may be from 30 to 300 nm. The multi-quantum well may be prepared by a well-known method.

It is to be noted that the semiconductor layer having a good activation efficiency of an impurity is preferably placed near the channel. In most cases, the distance is favorably 50 nm or less, preferably 30 nm or less. The distance between the semiconductor layer having a good activation efficiency of an impurity and the channel, and the concentration of an impurity included in the first insular impurity area are determined according to the characteristic features required for a semiconductor device.

When the semiconductor layer having a good activation efficiency of an impurity is inserted into the electric current passage existing between the channel and the outer take-out area of source and drain electrodes (electrode metal or high-concentration impurity layer), or when said semiconductor layer is inserted between the channel and said outer take-out area of electrodes, the direct effect of lowering the resistance between them can be brought about. This is because the presence of the semiconductor layer having a good activation efficiency of an impurity directly decreases the resistance of this layer.

A gate electrode is ordinarily formed on the surface of the semiconductor assembly constituting the semiconductor device, but can also be embedded under the surface.

Also, in the first and the second semiconductor layers constituting the channel, the wider-forbidden-bond semiconductor layer may be formed near the base of the semiconductor or in the opposite side.

Usefulness of this invention is explained in detail by an example of the compound semiconductor consisting of GaAs and AlGaAs.

As stated above, it is necessary to enlarge the band gap of AlGaAs to some extent in order to effectively generate carriers at the interface between GaAs and AlGaAs and give fast movement thereto. Therefore, the composition ratio of Al is usually about 0.3 in general. The thickness of this layer is conventionally determined within the range of 50 to 200 nm. In order to generate the fast carriers at the interface, the thickness of the AlGaAs layer of the same composition may be about 10 nm, but the above-mentioned range of thickness (50 to 200 nm) is needed for operation as a transistor. A GaAlAs crystal having an Al composition ratio of 0.25 or less is effective as a source of carrier supply since the impurity level, particularly the donor level of Si, is shallow at a value of 100 meV or less. Moreover, the activation efficiency of an impurity when carrying out the ion implantation is 2—10 times as high as that having Al composition ratio of 0.25 or more. Accordingly, when the source and drain areas of the field effect transistor are formed by implanting ions, the presence of the GaAs or GaAlAs layer having an Al composition ratio of 0.25 increases the activation efficiency and so decreases the electrode resistance, so that speeding-up of the device is brought about.

Thus this invention includes at least one layer of a semiconductor layer having a narrower forbidden band than the barrier layer to be prepared for constituting the carrier-transmitting area or a semiconductor layer having a high activation efficiency of an impurity. The thickness of this layer is preferably selected from the range of 1 to 200 nm. It is a matter of course that the determination of thickness depends on designs of semiconductor devices. The following is an explanation as to an example of GaAs-GaAlAs compounds. This invention, which differs from the conventional method of growing a single AlGaAs layer, is to provide a transistor produced by growing the AlGaAs barrier layer having an Al composition ratio of 0.25 or more to generate and keep carriers, next forming the AlGaAs layer or multilayer structure containing Al in a composition ratio of 0.25 or less, and then forming the electrode areas by ion implantation etc. The structure between this barrier layer and the gate electrode may be a multi-layer structure in the shape of quantum well, or a super lattice-structure. Also, the GaAlAs layer having a composition ratio of 0.25 or less may be produced by continuously changing the Al composition.

Another characteristic feature of this invention resides in that a depletion type transistor can easily be produced. Namely, since there is an area having an Al composition ratio of 0.25 or less between the channel and the gate electrode, the implantation of ions into this layer can easily control the amount of an impurity, so that a depletion type transistor having a voltage in the desired range can be produced by implanting a smaller amount of ions than in the case of a layer of an Al composition ratio of 0.25 or more. Accordingly, integration can easily be brought about by the employment of this invention.

It is to be noted that the barrier layer is desirable to be as thin as possible, but an excessively thin layer cannot imprison the carriers in the hetero interface. Therefore, the thickness of such layer should be determined so that the wave function of electrons is more than the extent that electrons permeate the AlGaAs layer (more than about 3 nm). On the other hand, it should not be more than 50 nm because an excessively thick layer is considered to be the same as an element in the conventional method. The more preferable thickness is 30 nm or less.

The above explanation was made as to an example of a GaAs-GaAlAs series compound, but other compound semi-conductor series can be used in this invention. For example, there are mentioned $Al_yGa_{1-y}As-Al_xGa_{1-x}As$, GaAs-AlGaAsP, InP-InGaAsP, InP-InGaAs, InAs-GaAsSb, and so on.

Brief description of the drawings

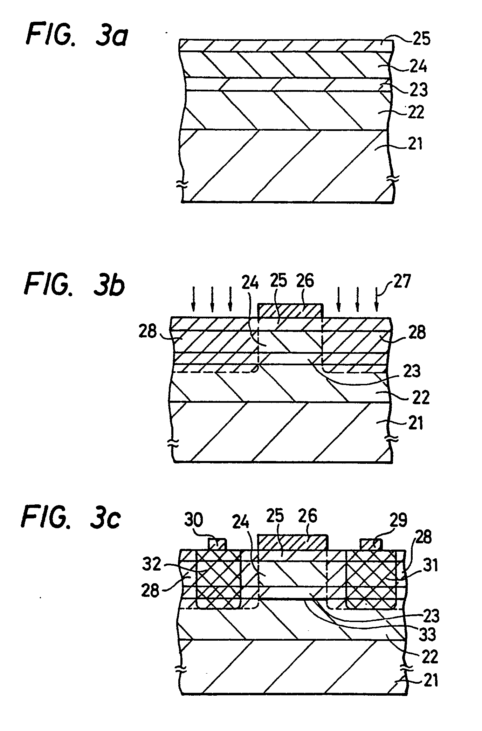

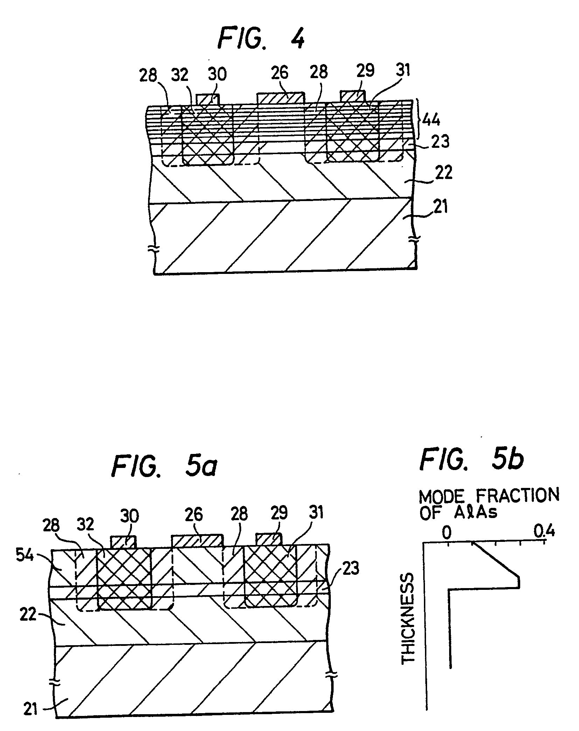

Figs. 1 and 2 are the energy diagrams of the conventional hetero-junction type field effect transistor. Fig. 3 is a section view showing the transistor-producing process of this invention. Fig. 4, Fig. 5a, and Figs. 6—10 are section views showing structures of the transistor of this invention. Fig. 5b is a graph showing the distribution of mixed crystal fraction of AlAs.

Detailed Description of preferred embodiments

This invention is illustrated in more detail by the following examples.

The principal processes are shown in Figs. 3a—3c.

On a semiconductive GaAs base 21, a GaAs layer 22 was grown about 1 μm thick at a base temperature of 600°C without intentionally adding any impurity and then an AlGaAs layer 23 including Al and Ga in a composition ratio of about 0.3:0.7 was grown about 10 nm thick by the well-known molecular beam epitaxy. Next, an AlGaAs layer 24 including Al and Ga in a composition ratio of about 0.2:0.8 was grown 50 nm thick, and then the shutter of Al cell was closed to grow a GaAs layer 25 about 10 nm (Fig. 3a).

The GaAs layer 22 and the GaAlAs layer 23 are the first and the second semiconductor alyers constituting the carrier-transmitting area as mentioned above. The channel is formed on the GaAs layer 22 side intentionally including no impurity. The AlGaAs layer 24 is a semiconductor layer of this invention, which forms a hetero-junction with the AlGaAs layer 23. The Al composition ratio of the AlGaAs layer 24 is smaller than that of the AlGaAs layer 23, so that the layer 24 has the smaller band gap. The GaAs layer 25 is further prepared for preventing the oxidation of the AlGaAs layer. The electric contact with electrodes prepared on the above layer becomes better.

On said epitaxial layer was formed a metal to be a gate electrode 26, for example Ti;W, about 2 μm thick. Using this metal electrode as a mask for implanting ions, $2 \times 10^{13} cm^{-2}$ of (self-aligned) Si ions 27 were implanted at 70 KeV. Lattice defects caused by the ion implantation were removed, and annealing was carried out at 800°C for 30 minutes to activate the ions. This impurity area is shown as 28 in Fig. 3b.

It is to be noted that other usable donor impurities than Si include Ge, Sn, Te, Se and S in this invention. Approximately $10^{13}$—$10^{14} cm^{-2}$ of ions are implanted. The impurity concentration is determined according to the amount of carriers to be generated or the characteristic features required for a device. Energy for implanting ions, depending on the element to be implanted, ranges from 50 to 200 KeV.

Next, in connection with the ion-implanted layer were formed source area 31 and drain area 32 by an ordinary alloying and further metal Al electrodes 29, 30 were formed to produce a field effect transistor (Fig. 3c). It is to be noted that 33 shows the carriers generated on the interface.

It is to be noted that the source and drain areas are formed by laminating, for example, Au-Ge alloy (200 nm)-Ni(10 nm)-Au-Ge alloy (300 nm) on the fixed portion and heating the resulting layers in $H_2$ at 400°C for 5 minutes.

In the thus produced field effect transistor, the carrier concentration in the source and drain areas was twice or more as much as that of the conventional single layer having an Al composition ratio of 0.3, and the electrode resistance was lowered to one-half, so that utility of this invention was proved.

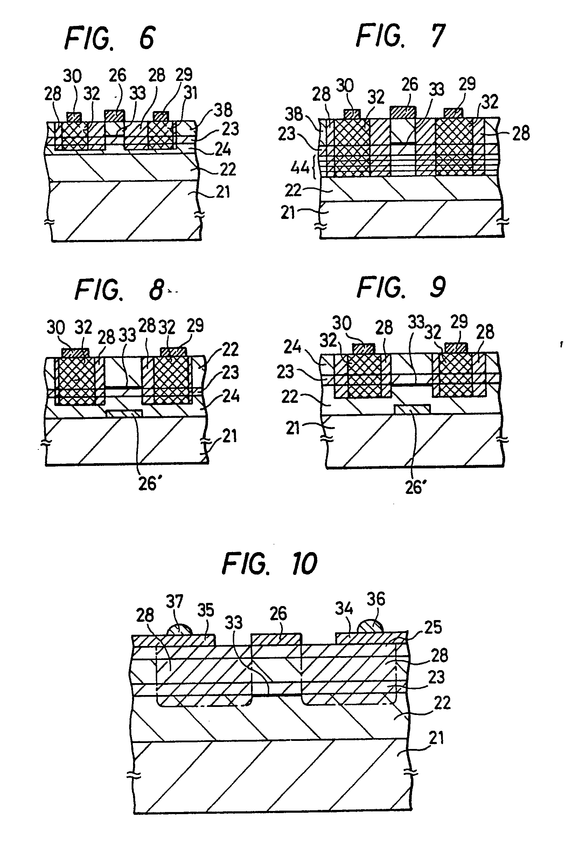

It is to be noted that Fig. 10 shows an example of forming the source and drain electrodes without alloying. The fundamental structure is the same as given in Fig. 3. An epitaxial GaAs layer 34, 35 containing $2 \times 10^{18} cm^{-3}$ of a high-concentration impurity was grown on the layer 25 and processed to obtain the fixed shape. And metal 36, 37 to be used for bonding was placed on this layer. This is an example of non-alloy type electrode.

Fig. 4 and Fig. 5 show other device examples produced in a manner similar to the embodiment of this invention. Fig. 4 shows an example having a multi-layer (super lattice) structure where each of ten $Al_xGa_{1-x}As$ (x=0.3) layers and each of ten GaAs layers are laminated in each thickness of 5 nm one after the other in the area 44. Fig. 5a shows an example of continuously decreasing the Al ratio to 0.1 (layer 54) after the formation of the barrier layer 23. It is to be noted that Figs. 4 and 5a have the same definition as in Fig. 3 as to the corresponding parts. Fig. 5b shows the change of mixed crystal ratio of Al in the area corresponding to that in Fig. 5a. In any case, it was observed that the obtained effect was about the same as in the above examples.

It is to be noted that in the examples of this invention, an impurity was not doped to any layer produced by the molecular beam epitaxy, but when an impurity was doped until the concentration reached $10^{16}$cm$^{-3}$, where was observed no essential change. This proved that the effect of this invention could be sufficiently maintained.

In the examples of this invention, the structure wherein the channel was formed by growing the GaAs layer on the GaAs base and preparing the carrier layer on the GaAs layer was examined, but the order of the laminated layers may not always be the same as above and can be changed variously as shown in Figs. 6—9.

The reference symbols in Figs. 6—9 are the same as given in the preceding drawings, which show the arrangement of the parts.

Fig. 6 shows that the GaAs layer 22, the $Al_{0.2}Ga_{0.8}As$ layer 24, the $Al_{0.3}Ga_{0.7}As$ layer 23 and the GaAs layer 38 were grown on the semiconductive GaAs base 21 in this order by the molecular beam epitaxy, each of which was grown without intentionally adding any impurities. Next, the gate electrode 26 was formed in a manner similar to the above-mentioned examples, and then the insular impurity area 28 was formed by implanting ions using this metal as the mask. The source and drain electrodes 31, 32 were formed by ordinary alloying to produce a semiconductive device. In this example, the barrier layer was the layer 23, and the channel was formed on the interface between the GaAs layer 38, and said barrier layer 23. 33 shows the carriers generated. The layer 24 having the high activation efficiency of impurity brought about the generation of the desired amount of carriers near the channel and could substantially lower the resistance value to the source and drain electrodes.

The example of Fig. 7 has a structure similar to that of Fig. 6 except that the semiconductive layer 24 consists of the super lattice layer of multi-quantum well 44. The super-lattice layer itself is the same as explained in Fig. 4. It is to be noted that also in this example the semiconductive layer 23 is the barrier layer and the channel is formed on the interface between the GaAs layer 38 and said barrier layer.

Fig. 8 shows an example wherein the gate electrode 26' was embedded. A GaAs layer containing a high impurity concentration was formed on the semiconductive GaAs base 21 in a thickness of 200 nm by the molecular beam epitaxy and etched in the width of the gate electrode. Then the $Al_{0.2}Ga_{0.8}As$ layer 24 (30 nm thick), the $Al_{0.3}Ga_{0.7}As$ layer 23 (10 nm) and the last GaAs layer 22 (50 nm) were grown.

Fig. 9 shows another example of the gate electrode 26' embedded. This example differs from that of Fig. 8 as to the points that the order of the laminated barrier layer 23 and the narrow forbidden band semiconductor layer 22 is reverse and the barrier layer is placed on the surface side of the semiconductor assembly.

It was recognized that the carrier concentration in the source and drain areas according to this invention increased 2—10 times as much as that of the conventional method and the electrode resistance decreased to one-half to one-tenth.

## Claims

1. A high electron mobility field-effect transistor comprising:
   a semiconductor substrate (21),
   a first semiconductor layer (22) and a second semiconductor layer (23) located over said substrate (21), said first semiconductor layer (22) having a relatively small forbidden band gap as compared with that of said second semiconductor layer (23), said first and second semiconductor layers (22, 23) forming a hetero-junction therebetween,
   a third semiconductor layer (24) located in contact with said second semiconductor layer (23), said third semiconductor layer having a higher activation efficiency of impurity as compared with that of said second semiconductor layer (23),
   source and drain means (28, 29, 30, 31, 32) each comprising an impurity doped region (28) connected electrically to a channel generated in said first semiconductor layer (22) adjacent to said hetero-junction,
   gate means (26) for controlling carriers in said channel between said pair of impurity doped regions (28),
   and a region under said gate means (26) in said second semiconductor layer (23), with $10^{16}$cm$^{-3}$ or less of impurities being included in said region.

2. The field-effect transistor of claim 1, wherein the distance between said third semiconductor layer (24) and the hetero-junction formed by said first and second semiconductor layers (22, 23) does not exceed 50 nm.

3. The field-effect transistor of claims 1 or 2, wherein said third semiconductor layer (44) is formed by a multi-quantum well prepared by laminating comparatively wider forbidden band semiconductor layers and comparatively narrower forbidden band semiconductor layers upon each other.

4. The field-effect transistor of claim 3, wherein the thickness of each layer of said multi-quantum well structure (44) is between 1 and 10 nm.

5. The field-effect transistor of any of claims 1 to 4, wherein said third semiconductor layer (24) is formed between said gate means (26) and the hetero-junction formed by said first and second semiconductor layers (22, 23).

## Patentansprüche

1. Feldeffekttransistor mit hoher Elektronenbeweglichkeit, umfassend

eine Halbleitersubstrat (21),

eine erste Halbleiterschicht (22) und eine zweite Halbleiterschicht (23), die über dem Substrat (21) angeordnet sind, wobei die erste Halbleiterschicht (22) im Vergleich mit der zweiten Halbleiterschicht (23) einen verhältnismäßig kleinen Bandabstand aufweist und die erste und die zweite Halbleiterschicht (22, 23) miteinander einen Hetero-Übergang bilden,

eine in Kontakt mit der zweiten Halbleiterschicht (23) angeordnete dritte Halbleiterschicht (24), die einen höheren Störstoffaktivierungs-Wirkungsgrad hat als die zweite Halbleiterschicht (23),

Source- und Draineinrichtungen (28, 29, 30, 31, 32), die jeweils einen störstoffdotierten Bereich (28) enthalten, der mit einem in der ersten Halbleiterschicht (22) angrenzend an den Hetero-Übergang gebildeten Kanal elektrisch verbunden ist,

eine Gate-Einrichtung (26) zur Steuerung von Ladungsträgern in dem Kanal zwischen dem Paar von störstoffdotierten Bereichen (28), und

einen unter der Gate-Einrichtung (26) in der zweiten Halbleiterschicht (23) befindlichen Bereich, der $10^{16}$cm$^{-3}$ oder weniger Störstoffe enthält.

2. Feldeffekttransistor nach Anspruch 1, wobei der Abstand zwischen der dritten Halbleiterschicht (24) und dem von der ersten und der zweiten Halbleiterschicht (22, 23) gebildeten Hetero-Übergang 50 nm nicht überschreitet.

3. Feldeffekttransistor nach Anspruch 1 oder 2, wobei die dritte Halbleiterschicht (44) von einer Mehrquanten-Wanne gebildet ist, die durch Übereinanderlaminieren von Halbleiterschichten mit verhältnismäßig größerem Bandabstand und solchen mit verhältnismäßig kleinerem Bandabstand hergestellt ist.

4. Feldeffekttransistor nach Anspruch 3, wobei die Dicke jeder Schicht der Mehrquanten-Wannenstruktur (44) zwischen 1 und 10 nm liegt.

5. Feldeffekttransistor nach einem der Ansprüche 1 bis 4, wobei die dritte Halbleiterschicht (24) zwischen der Gate-Einrichtung (26) und dem von der ersten und der zweiten Schicht (22, 23) gebildeten Hetero-Übergang ausgebildet ist.

## Revendications

1. Transistor à effet de champ, dans lequel les électrons ont une grande mobilité, comprenant:

un substrat semiconducteur (21),

une première couche semiconductrice (22) et une seconde couche semiconductrice (23), situées au-dessus dudit substrat (21), ladite première couche semiconductrice (22) possédant une bande interdite relativement étroite par rapport à celle de ladite seconde couche semiconductrice (23), lesdites première et seconde couches semiconductrices (22, 23) formant entre elles une hétérojonction,

une troisième couche semiconductrice (24) placée en contact avec ladite seconde couche semiconductrice (23), ladite troisième couche semiconductrice possédant un rendement supérieur d'activation d'une impureté par rapport à celui présenté par ladite seconde couche semiconductrice (23),

des moyens formant source et drain (28, 29, 30, 31, 32) comportant chacun une région (28) dopée par une impureté et raccordés électriquement à un canal produit dans ladite première couche semiconductrice (22) au voisinage de ladite hétérojonction,

des moyens formant grille (26) servant à commander des porteurs dans ledit canal entre les régions dudit couple de régions (28) dopées par une impureté, et

une région, située au-dessus desdits moyens formant grille (26) dans ladite seconde couche semiconductrice (23) et dans laquelle sont inclus $10^{16}$cm$^{-3}$ ou moins d'impuretés.

2. Transistor à effet de champ selon la revendication 1, dans lequel la distance entre ladite troisième couche semiconductrice (24) et l'hétérojonction formée par lesdites première et seconde couches semiconductrices (22, 23) ne dépasse pas 50 nm.

3. Transistor à effet de champ selon la revendication 1 ou 2, dans lequel ladite troisième couche semiconductrice (44) est formée par un puits de quanta multiples, formé par la superposition de couches semiconductrices possédant des bandes interdites comparativement plus larges et de couches semiconductrices possédant des bandes interdites comparativement plus étroites.

4. Transistor à effet de champ selon la revendication 3, dans lequel l'épaisseur de chaque couche de ladite structure (44) formant puits de quanta multiples est comprise entre 1 et 10 nm.

5. Transistor à effet de champ selon l'une quelconque des revendications 1 à 4, dans lequel la troisième couche semiconductrice (24) est formée entre lesdits moyens formant grille (28) et l'hétérojonction formée par lesdites première et seconde couches semiconductrices (22, 23).

## FIG. 1

## FIG. 2

FIG. 3a

```
                                    25
                                    24
                                    23
                                    22
                                    21
```

FIG. 3b

```
            24  25  26           27
    28                           28
                                 23
                                 22
                                 21
```

FIG. 3c

```
        30   24   25  26        29
                                   28
    32                             31
    28
                                   23
                                   33
                                   22
                                   21
```

## FIG. 4

28 32 30     26   28    29    31

44
23
22
21

## FIG. 5a

28 32   30     26   28   29   31

54

23

22

21

## FIG. 5b

MODE FRACTION
OF AℓAs

0       0.4

THICKNESS

## FIG. 6

## FIG. 7

## FIG. 8

## FIG. 9

## FIG. 10